# EUROPÄISCHE PATENTSCHRIFT

(11) **EP 0 697 110 B1**
(45) Veröffentlichungstag und Bekanntmachung des Hinweises auf die Patenterteilung: **22.07.1998**
(21) Anmeldenummer: 94914319.2
(22) Anmeldetag: 05.05.1994
(51) Int. Cl.: G01N 27/414, G01N 33/00, G01L 9/00, G01P 15/08

(54) **Verfahren zur Herstellung eines Suspended Gate Field Effect Transistors**
Process of Production of a Suspended Gate Field Effect Transistor
Procédé de fabrication d'un Suspended Gate Field Effect Transistor

(30) Priorität: 05.05.1993 DE 4314888
(43) Veröffentlichungstag der Anmeldung: 21.02.1996
(60) Teilanmeldung: 97114672.5
(73) Patentinhaber: Siemens Aktiengesellschaft, 80506 München (DE)
(72) Erfinder: Eisele, Ignaz, D-82057 Icking (DE); Flietner, Bertrand, D-81543 München (DE); Lechner, Josef, D-83043 Bad Aibling (DE)
(86) Internationale Anmeldenummer: DE9400505
(87) Internationale Veröffentlichungsnummer: WO9425863

(56) Entgegenhaltungen:
- EP-A- 0 341 964
- AT-B- 241 536
- DE-A- 4 239 319
- DE-C- 3 834 189
- US-A- 4 469 719

## Beschreibung

Die Erfindung bezieht sich in erster Linie auf die Verbesserung des SGFET (Suspended Gate Field Effect Transitors) z. B. als Sensor. Der für die Strukturierung beim Aufdampfen mit Hilfe von Masken relevante Stand der Technik ist in den Patentschriften AT - PS 241 536, DD - PS 027 798 und US - PS 4 469 719 dargelegt.

Beim SGFET [Patentschrift US 4 411 741] kann die sensitive Schicht entweder elektrochemisch oder durch physikalische [Patentschrift DE 3834189 Cl] Methoden wie Aufstäuben oder Aufdampfen abgeschieden werden. Da sich die sensitive Schicht zwischen dem Gate und dem Kanal des Transistors befinden muß, folgen nach dem Aufbringen der sensitiven Schicht mit physikalischen Methoden andere Prozeßschritte wie das Herstellen des Gates oder das Ätzen des Spacers. Diese Schritte können die sensitive Schicht verändern bzw. nur wenige Materialien sind kompatibel zu diesen späteren Schritten. Dies engt die Wahl der sensitiven Schicht stark ein.

Die Aufgabe besteht darin einen integierbaren SGFET herzustellen, dessen chemisch sensitive Schicht durch keinen weiteren Prozeßschritt verändert wird.

Diese Aufgabe wird durch die Verfahren nach den Patentansprüchen 1 bis 3 gelöst.

Durch das hier vorgestellte Verfahren des Abscheidens durch eine Maske, die auch das Gate bildet, können alle Materialien als sensitive Schicht verwendet werden, die durch gerichtete Abscheidung wie Aufstäuben oder Dampfen aufgebracht werden können. Diese Schichten müssen zu keinem Ätzschritt kompatibel sein, da die sensitive Schicht als letztes aufgebracht wird.

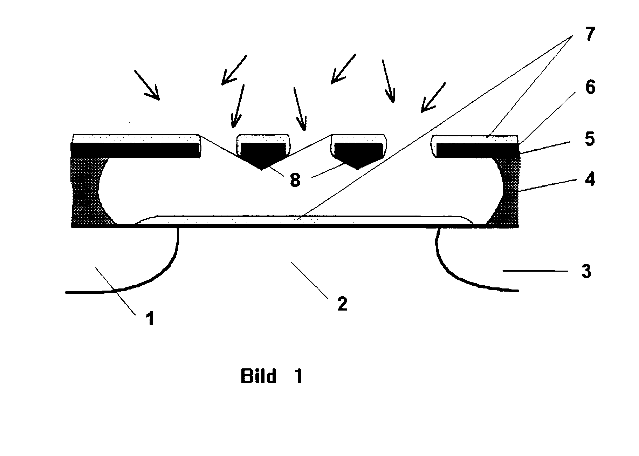

In Bild 1 ist ein SGFET, der das neue Verfahren des Abscheidens der chemisch sensitiven Schicht erlaubt, schematisch dargestellt. Über dem Kanal (2) zwischen Source (1) und Drain (3) befindet sich eine dünne Schicht aus Siliziumdioxid und darauf eine aus Siliziumnitrid (im Bild nicht näher bezeichnet). Darauf wird Siliziumdioxid (4), dann Siliziumnitrid (5) und schließlich Metall (6) abgeschieden. Das Metall bildet das Gate und die Nitridschicht stellt eine Passivierung der unteren Metalloberfläche dar. Diese ist sinnvoll um möglichst nur die Reaktion der sensitiven Schicht mit dem Sensor zu messen, da dieser grundsätzlich die Änderung der Austrittsarbeitsdifferenz der Materialien ober- und unterhalb des Hohlraumes anzeigt. Dann wird ein Photolackschritt durchgeführt, so daß ein Durchätzen der Nitrid/Metall-Schicht strukturiert erfolgen kann. Nach diesem Schritt wird die dicke Oxidschicht naßchemisch durch die Löcher in der Maske geätzt und so das Siliziumdioxid über dem Kanalbereich des Transistors entfernt. Die Nitridschicht und das Metall (z.B. Platin) werden hierbei nicht geätzt. Durch die Wahl des Nitrid/Siliziumdioxid Schichtsystems wird die Herstellung eines definierten Hohlraumes gewährleistet, da hierfür selektive Ätz- und definierte Abscheidemethoden zur Verfügung stehen. Auf die Struktur kann jetzt in einem letzten Schritt die chemisch sensitive Schicht (7) abgeschieden werden. Dabei müssen die Stegbreite und die Hohlraumhöhe in der gleichen Größenordnung liegen, und die Steghöhe darf höchstens die Größe der Lochbreite besitzen, damit auch die Fläche direkt unter den Stegen bedeckt wird. Oder anders ausgedrückt: Der Kernschatten (8) der Maskenteile über dem Transistorgebiet darf nicht bis auf das Substrat reichen.

Dieses neue Verfahren zur Herstellung des SGFET hat folgende Vorteile:
1. Die Beschichtung ist keinem weiteren Prozeßschritt ausgesetzt und wird so nicht mehr verändert, bzw, es können Materialien benützt werden, die von einem weiteren Prozeßschritt zerstört werden würden.
2. Es können Materialien benützt werden, die in der Halbleitertechnologie normalerweise nicht verwendet werden, da sie Fertigungsanlagen für sonst nachfolgende Prozesse in unzulässigerweise verschmutzen würden.
3. Da alle Herstellungsschritte bis zur letzten Beschichtung für unterschiedliche Materialien identisch sein können, lassen sich auch kleine Stückzahlen für ein bestimmtes sensitives Material kostengünstig herstellen.

Für einen Gassensor, gibt es zwei sinnvolle Verbindungen zu dem zu vermessenden Gasvolumen. Erstens eine möglichst kurze Gaszuführung mit großem Querschnitt um den Sensor schnell den aktuellen Konzentrationen auszusetzen. Zweitens eine lange Gaszuführung mit kleinem Querschnitt um eine bestimmte chemisorbierte Oberflächenbedeckung der sensitiven Schicht zu erhalten, Laufzeiteffekte auszunutzen oder Ventile und Pumpen anschließen zu können. Beide Arten der Gaszuführung sind mit dem hier vorgestellten Sensor möglich. Eine kurze

Gaszuführung mit großem Querschnitt läßt sich durch eine offengebliebene Maske verwirklichen. Das zu vermessende Gasvolumen beginnt unmittelbar oberhalb der Maske. Mit dieser Technik läßt sich auch eine Gittermaske über Gassensoren, die auf anderen Meßmethoden beruhen, wie z. B. Leitfähigkeits- und kapazitive Sensoren mit Interdigitalstrukturen, herstellen. Diese Maske dient dann als Schutz gegen Partikel, wobei die maximale Größe der durchkommenden Partikel durch die Löchergröße gegeben ist.

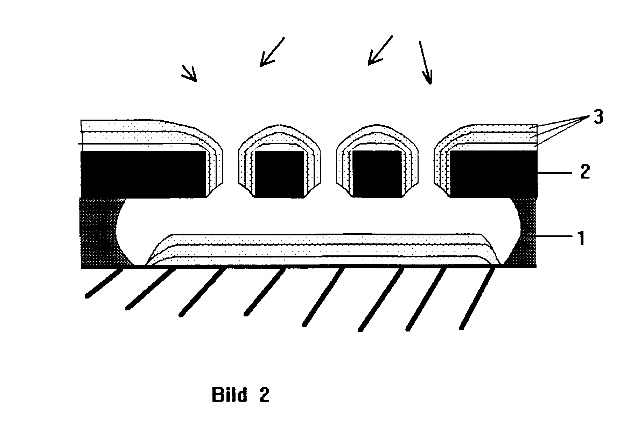

Eine lange Gaszuführung mit kleinem Querschnitt kann folgendermaßen erreicht werden. Die Maske über dem Hohlraum wird verschlossen. Dies kann dadurch geschehen, daß das Aufbringen der sensitiven Schicht relativ isotrop erfolgt und so nicht nur eine Schicht auf den Isolator über dem Kanal abgeschieden wird, sondern auch die Löcher in der Maske langsam zuwachsen. Dies ist in Bild 2 dargestellt. Die im aktiven Bereich weggeätzte Siliziumdioxidschicht (1) und die Nitrid/Metall-Schicht (2) sind hergestellt wie oben beschrieben. Dann wird soviel chemisch sensitives Material (3) abgeschieden, daß die Löcher in der Maske geschlossen werden. Hierfür ist eine große Steghöhe im Verhältnis zur Lochbreite günstig. Sowohl schattenfreies Abscheiden unter die Maske als auch Verschließen der Löcher in einem Schritt ist möglich, wenn sowohl Stegbreite und Hohlraumhöhe als auch Steghöhe und Lochbreite jeweils in der gleichen Größenordnung liegen.

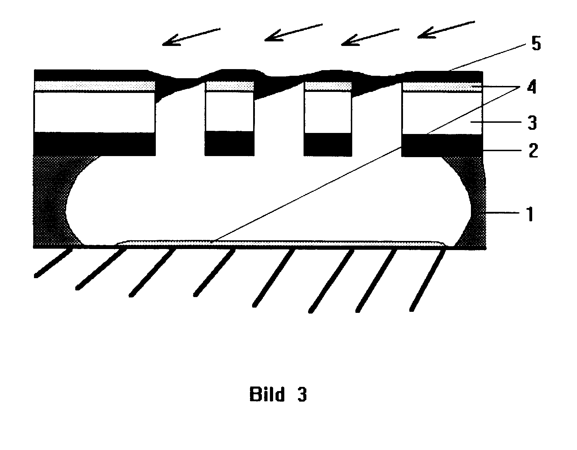

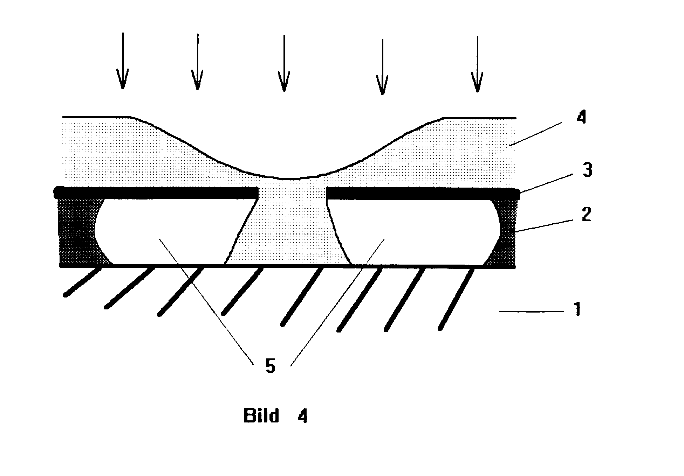

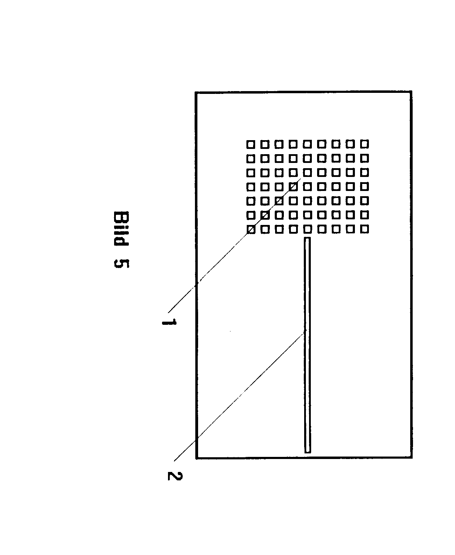

Die Maske kann auch in einem zusätzlichen Schritt verschlossen werden, bei dem ein Material unter einem so flachen Winkel aufgebracht wird, daß dieses die Maske nicht durchqueren kann, d.h. nicht auf die sensitve Schicht abgeschieden wird, und so die Löcher der Maske verschließt. Dies ist in Bild 3 dargestellt. Der Aufbau kommt wie für Bild 1 beschrieben zustande. Es sind: Siliziumdioxid (1), Nitrid (2), Metall (3). Nach der chemisch sensitiven Schicht (4) wird jetzt ein Material (5) unter sehr flachen Winkel zum Verschließen der Löcher abgeschieden. Die ideale Quelle für dieses Verfahren ist ringförmig. Falls die Quelle ungefähr punktförmig ist, ist ein Drehen der Sensorstrukur in der Maskenebene hilfreich. Unabhängig davon mit welcher Methode die Maske verschlossen wurde, kann anschließend Klebstoff oder eine aushärtende Flüssigkeit als mechanischer oder chemischer Schutz aufgebracht werden. Der Anschluß an das zu vermessende Gasvolumen erfolgt folgendermaßen. Die Metall/Nitrid-Maske wird lateral derart strukturiert (in Bild 5 dargestellt), daß Gaskanäle (2 ein Gaskanal) von dem Gasvolumen über dem Transistorgebiet (1) wegführen. Den vertikalen Aufbau eines solchen Gaskanales zeigt Bild 4. Auf dem Substrat (1) wird, wie bei der Herstellung des SGFET bereits beschrieben, erst eine Siliziumdioxidschicht (2) aufgebracht, dann eine Nitrid- oder Nitrid/Metall-Schicht (3) und diese strukturiert. Eine Metallschicht ist nicht notwendig, stört jedoch auch nicht und kann mitaufgebracht werden um die Gesamtzahl der Photoschritte möglichst klein zu halten. Nach dem naßchemischen Herausätzen der Oxidschicht wird soviel Material (4) abgeschieden, daß dieses Material von der unteren bis zur oberen Nitridschicht reicht und so das Loch in der Maske verschließt. Es verbleiben die Gaskanäle (5). Ein möglichst senkrechtes Abscheiden des Materials (4) wäre hier günstig, ist jedoch nicht notwendig, wenn die obere Nitridschicht (3) hinreichend stark unterätzt ist.

Auch die Verfahren zum Verschließen des Hohlraumes über dem Transistor eignen sich zum Herstellen von Gaskanälen, sind auf der einen Seite etwas komplizierter, da dort das Material nicht die untere Nitridmaske mit der oberen verbinden darf, auf der anderen Seite können die gleichen Prozeßschritte angewandt werden.

Mit dieser Technologie läßt sich auch ein Drucksensor aufbauen. Wird der Hohlraum ohne Anschluß eines Gaskanals verschlossen, so ist eine bestimmte Gasmenge in diesem Hohlraum eingeschlossen. Wenn die Maske die richtige mechanische Stabilität aufweist, wird sie durch den Druckunterschied zwischen Hohlraum und Umgebung verbogen. Anhand des Source-Drain-Stromes bei konstanter Gatespannung kann auf den Abstand der Maske vom Kanal des Transistors und damit auf den Druckunterschied geschlossen werden. Es kann ein solcher Drucksensor auch mit Gaskanal hergestellt werden und dieser Gaskanal bei einem definierten Druck verschlossen werden. So kann der Arbeitsbereich des Sensors eingestellt werden.

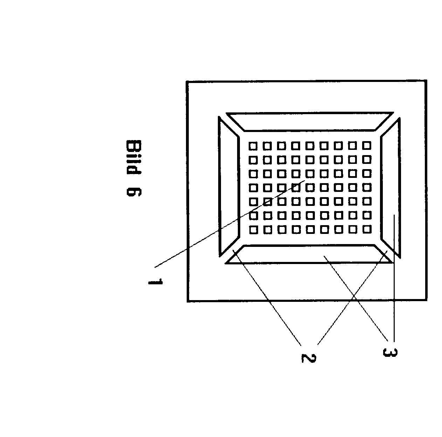

Läßt man den Gaskanal offen oder am Rand des Transistorbereiches der Nitridmaske so große Löcher, daß diese nicht verschlossen werden (Bild 6: 1 Transistorbereich, 2 verbleibende Stege, 3 Löcher), so herrscht im Hohlraum der gleiche Druck wie in der Umgebung. Schallwellen, die auf die Maske treffen, können diese auslenken und die Auslenkung kann mit dem Transistor gemessen werden. So erhält man ein Mikrophon.

Wird eine Struktur wie die für ein Mikrophon von der Umgebungsluft abgeschirmt,
so kann man sie als Beschleunigungssensor benützen. Die Maske wird aufgrund ihrer trägen Masse bei einer Beschleunigung des Gehäuses senkrecht zur Maskenebene ausgelenkt und diese Auslenkung kann wie bei dem Drucksensor und dem Mikrophon gemessen werden.

## Patentansprüche

1. Verfahren zur Herstellung eines Suspended Gate Field Effect Transistors,
- bei dem auf ein Substrat, das ein Sourcegebiet, ein Draingebiet und einen dazwischen angeordneten Kanal umfaßt, eine dünne Schicht aus Siliziumdioxid aufgebracht wird,
- bei dem auf die dünne Schicht aus Siliziumdioxid eine erste Siliziumnitridschicht, eine Siliziumdioxidschicht, eine zweite Siliziumnitridschicht und eine Metallschicht aufgebracht werden,
- bei dem mit Hilfe einer Photolacktechnik die Metallschicht und die zweite Siliziumnitridschicht so strukturiert werden, daß eine Maske entsteht,
- bei dem in einem Ätzprozeß, der Siliziumdioxid selektiv zu Siliziumnitrid und Metall angreift, unterhalb der Maske durch Ätzen der Siliziumdioxidschicht ein Hohlraum gebildet wird,
- bei dem unterhalb der Maske eine chemisch sensitive Schicht abgeschieden wird,
- bei dem die Abscheidung der chemisch sensitiven Schicht aus verschiedenen Richtungen erfolgt, so daß eine schattenfreie, ganzflächige Beschichtung unterhalb der Maske erfolgt,
- bei dem die Maske als Gateelektrode oder Membran einen funktionalen Bestandteil des Suspended Gate Field Effect Transistors bildet.

2. Verfahren nach Anspruch 1, **dadurch gekennzeichnet,**
daß die Maske durch eine Abscheidung verschlossen wird.

3. Verfahren nach Anspruch 2,
**dadurch gekennzeichnet,**
daß die Maske beim Abscheiden der chemisch sensitiven Schicht verschlossen wird.

4. Verfahren nach Anspruch 1 bis 3,
**dadurch gekennzeichnet,**
daß als Maske ein Gitter eingesetzt wird.

5. Verfahren nach Anspruch 1 bis 3,
**dadurch gekennzeichnet,**
daß als Maske eine Schicht mit Wabenstruktur eingesetzt wird.

6. Verfahren nach Anspruch 1 bis 3,
**dadurch gekennzeichnet,**
daß als beschichtete Fläche der Teil eines Gassensors eingesetzt wird.

7. Verfahren nach Anspruch 1 bis 3,
**dadurch gekennzeichnet,**
daß als beschichtete Fläche die sensitive Schicht eines Gassensors eingesetzt wird.

8. Verfahren nach Anspruch 1 bis 3,
**dadurch gekennzeichnet,**
daß als beschichtete Fläche ein Teil eines Gassensors, dessen Meßprinzip auf Austrittarbeitsänderung bei Gasadsorption beruht, eingesetzt wird.

9. Verfahren nach Anspruch 1 bis 3,
**dadurch gekennzeichnet,**
daß die Fläche, auf der die Schicht abgeschieden wird, bereits strukturiert wurde.

10. Verfahren nach Anspruch 1 bis 3,
**dadurch gekennzeichnet,**
daß nachdem der Hohlraum verschlossen worden ist, ein Klebstoff oder eine aushärtende Flüssigkeit aufgebracht wird ohne daß Kapillareffekte auftreten.

11. Verfahren nach Anspruch 1 bis 3 und einem der Ansprüche 6 bis 10, **dadurch gekennzeichnet**, daß
- der Hohlraum an mindestens einen Gaskanal angeschlossen wird,
- zur Erzeugung des Gaskanals eine Siliziumdioxidschicht und darüber eine Siliziumnitridschicht aufgebracht werden,
- zur Erzeugung des Gaskanals die Siliziumdioxidschicht so strukturiert wird, daß eine Maske entsteht,
- zur Erzeugung des Gaskanals die Siliziumdioxidschicht in einem Ätzprozeß entfernt und die Maske anschließend verschlossen wird.

12. Verfahren nach Anspruch 1 bis 3, dadurch gekennzeichnet, daß der Suspended Gate Field Effect Transistor anschließend als Drucksensor oder Teil eines Drucksensors verwendet wird.

13. Verfahren nach Anspruch 1 bis 3, dadurch gekennzeichnet, daß der Suspended Gate Field Effect Transistor anschließend als Mikrophon oder Teil eines Mikrophons verwendet wird.

14. Verfahren nach Anspruch 3, dadurch gekennzeichnet, daß der Suspended Gate Field Effect Transistor anschließend als Detektor für den photoakustischen Effekt verwendet wird.

15. Verfahren nach Anspruch 1 bis 3, dadurch gekennzeichnet, daß der Suspended Gate Field Effect Transistor anschließend als Beschleunigungssensor oder Teil eines Beschleunigungssensors verwendet wird.

## Claims

1. Process for producing a suspended-gate field-effect transistor,
- in which a thin layer of silicon dioxide is applied to a substrate which comprises a source region, a drain region and a channel disposed in between,
- in which a first silicon nitride layer, a silicon dioxide layer, a second silicon nitride layer and a metal layer are applied to the thin layer of silicon dioxide,
- in which the metal layer and the second silicon nitride layer are structured with the aid of a photoresist procedure in such a way that a mask is produced,
- in which a cavity is formed beneath the mask by etching the silicon dioxide layer in an etching process which attacks silicon dioxide selectively with respect to silicon nitride and metal,
- in which a chemically sensitive layer is deposited underneath the mask,
- in which the deposition of the chemically sensitive layer takes place from different directions so that a shadow-free, surface-wide coating takes place underneath the mask,
- in which the mask forms, as gate electrode or membrane, a functional component of the suspended-gate field-effect transistor.

2. Process according to Claim 1, characterized in that the mask is closed by a deposit.

3. Process according to Claim 2, characterized in that the mask is closed during the deposition of the chemicaly sensitive layer.

4. Process according to Claims 1 to 3, characterized in that a grid is used as mask.

5. Process according to Claims 1 to 3, characterized in that a layer with honeycomb structure is used as mask.

6. Process according to Claims 1 to 3, characterized in that the part of a gas sensor is used as coated area.

7. Process according to Claims 1 to 3, characterized in that the sensitive layer of a gas sensor is used as coated area.

8. Process according to Claims 1 to 3, characterized in that a part of a gas sensor whose principle of measurement is based on a change in work function during gas adsorption is used as coated area.

9. Process according to Claims 1 to 3, characterized in that the area on which the layer is deposited was already structured.

10. Process according to Claims 1 to 3, characterized in that, after the cavity has been closed, an adhesive or a liquid which hardens is applied without capillary effects occuring.

11. Process according to Claims 1 to 3 and one of Claims 6 to 10, characterized in that
- the cavity is connected to at least one gas channel,
- a silicon dioxide layer and, on top of the latter, a silicon nitride layer are deposited to produce the gas channel,
- to produce the gas channel, the silicon dioxide layer is structured in such a way that a mask is produced,
- to produce the gas channel, the silicon dioxide layer is removed in an etching process and the mask is then closed.

12. Process according to Claims 1 to 3, characterized in that the suspended-gate field-effect transistor is then used as pressure sensor or part of a pressure sensor.

13. Process according to Claims 1 to 3, characterized in that the suspended-gate field-effect transistor is then used as microphone or part of a microphone.

14. Process according to claim 3, characterized in that the suspended-gate field-effect transistor is then used as detector for the photoacoustic effect.

15. Process according to Claims 1 to 3, characterized in that the suspended-gate field-effect transistor is then used as acceleration sensor or part of an acceleration sensor.

## Revendications

1. Procédé de fabrication d'un transistor à effet de champ à porte suspendue,
- dans lequel on dépose une mince couche de dioxyde de silicium sur un substrat qui comprend une région de source, une région de drain et un canal ménagé entre ces dernières,
- dans lequel on dépose sur la mince couche de dioxyde de silicium, une première couche de nitrure de silicium, une couche de dioxyde de silicium, une deuxième couche de nitrure de silicium et une couche métallique,
- dans lequel on structure la couche métallique et la deuxième couche de nitrure de silicium en appliquant une technique de laque photosensible de manière qu'il se forme un masque,
- dans lequel, dans un processus de gravure, on attaque sélectivement le dioxyde de silicium par rapport au nitrure de silicium et au métal, et il se forme une cavité au-dessous du masque sous l'effet de l'attaque de la couche de dioxyde de silicium,
- dans lequel on dépose une couche chimiquement sensible au-dessous du masque,
- dans lequel le dépôt de la couche chimiquement sensible s'effectue dans différentes directions de manière qu'il se produise un recouvrement sur toute la surface, sans ombre, sous le masque,
- dans lequel le masque, utilisé comme électrode de porte ou comme membrane, forme une partie constitutive fonctionnelle du transistor à effet de champ à porte suspendue.

2. Procédé selon la revendication 1,
caractérisé
en ce que le masque est obturé par un dépôt.

3. Procédé selon la revendication 2,
caractérisé
en ce que le masque est obturé lors du dépôt de la couche chimiquement sensible.

4. Procédé selon l'une des revendications 1 à 3,
caractérisé
en ce qu'on utilise une grille en tant que masque.

5. Procédé selon l'une des revendications 1 à 3,
caractérisé
en ce qu'on utilise comme masque une couche ayant une structure de nid d'abeilles.

6. Procédé selon l'une des revendications 1 à 3,
caractérisé
en ce qu'on utilise comme surface revêtue la partie d'un capteur de gaz.

7. Procédé selon l'une des revendications 1 à 3,
caractérisé
en ce qu'on utilise comme surface revêtue la couche sensible d'un capteur de gaz.

8. Procédé selon l'une des revendications 1 à 3,
caractérisé
en ce qu'on utilise comme surface revêtue une partie d'un capteur de gaz dont le principe de mesure repose sur une variation du travail de sortie dans un processus d'adsorption de gaz.

9. Procédé selon l'une des revendications 1 à 3,
caractérisé
en ce que la surface sur laquelle la couche est déposée a été préalablement structurée.

10. Procédé selon l'une des revendications 1 à 3,
caractérisé
en ce qu'après que la cavité a été fermée, on dépose une colle ou un liquide durcissable, sans qu'il se produise d'effets de capillarité.

11. Procédé selon l'une des revendications 1 à 3 et l'une des revendications 6 à 10,
caractérisé
- en ce que la cavité est raccordée à au moins un canal de gaz,
- en ce que, pour produire le canal de gaz, on dépose une couche de dioxyde de silicium et, par dessus, une couche de nitrure de silicium,
- en ce que, pour produire le canal de gaz, on structure la couche de dioxyde de silicium de manière qu'il se forme un masque,
- en ce que, pour produire le canal de gaz, on élimine la couche de dioxyde de silicium dans un processus de gravure et on obture ensuite le masque.

12. Procédé selon l'une des revendications 1 à 3, caractérisé en ce que le transistor à effet de champ à porte suspendue est ensuite utilisé comme capteur de pression ou comme partie d'un capteur de pression.

13. Procédé selon l'une des revendications 1 à 3, caractérisé en ce que le transistor à effet de champ à porte suspendue est ensuite utilisé comme microphone ou comme partie d'un microphone.

14. Procédé selon la revendication 3, caractérisé en ce que le transistor à effet de champ à porte suspendue est ensuite utilisé comme détecteur pour l'effet photo-acoustique.

15. Procédé selon l'une des revendications 1 à 3, caractérisé en ce que le transistor à effet de champ à porte suspendue est ensuite utilisé comme capteur d'accélération ou comme partie d'un capteur d'accélération.
